(19) Europäisches Patentamt
European Patent Office
Office européen des brevets

(11) Publication number: 0 359 827 A1

(12) # EUROPEAN PATENT APPLICATION published in accordance with Art. 158(3) EPC

(21) Application number: 89902293.3

(22) Date of filing: 10.02.89

(86) International application number: PCT/JP89/00133

(87) International publication number: WO 89/07579 (24.08.89 89/20)

(51) Int. Cl.5: C01G 29/00, C04B 35/00, H01B 12/00, H01B 13/00

(30) Priority: 12.02.88 JP 30514/88
23.02.88 JP 40521/88
26.02.88 JP 43559/88
07.03.88 JP 53163/88
14.03.88 JP 59598/88
07.04.88 JP 85599/88
07.04.88 JP 85600/88
01.07.88 JP 164364/88
11.07.88 JP 172186/88
26.08.88 JP 212110/88
31.08.88 JP 216756/88

(43) Date of publication of application: 28.03.90 Bulletin 90/13

(84) Designated Contracting States: DE FR GB IT NL

(71) Applicant: MITSUBISHI KASEI CORPORATION
5-2, Marunouchi 2-chome Chiyoda-ku
Tokyo 100(JP)

(72) Inventor: ENDO, Hozumi
607-10, Kawana Fujisawa-shi
Kanagawa 251(JP)
Inventor: KIJIMA, Naoto
3, Sakuradai Midori-ku
Yokohama-shi Kanagawa 227(JP)
Inventor: TSUCHIYA, Jun
1189-6-402, Kamisakunobe Takatsu-ku
Kawasaki-shi Kanagawa 213(JP)
Inventor: SUMIYAMA, Akihiko
23-4, Tana-cho Midori-ku
Yokohama-shi Kanagawa 227(JP)
Inventor: MIZUNO, Masaaki
5-1, Tsutsujigaoka Midori-ku
Yokohama-shi Kanagawa 227(JP)
Inventor: YOSHITOMI, Toshihiko
4-7, Wakabadai Asahi-ku
Yokohama-shi Kanagawa 241(JP)
Inventor: OGURI, Yasuo
1-56-4, Goutokuji Setagaya-ku
Tokyo 154(JP)

(74) Representative: Wächtershäuser, Günter, Dr.
Tal 29
D-8000 München 2(DE)

EP 0 359 827 A1

(54) **SUPERCONDUCTING OXIDE AND METHOD OF PRODUCING THE SAME.**

(57) A superconducting substance of the invention is composed of a bismuth oxide, or a bismuth oxide in which Bi is partly substituted by Pb, Cr or V. It exhibits Tc of the class of 120 K. The superconduc-

ting substance is obtained by mixing raw material compounds of these components, and effecting the primary firing at lower than 820°C until no bismuth oxide is recognized and then effecting the secondary firing at 865 to 880°C. The composition represented by $Bi_2Sr_2Ca_2CuOx$ is characterized by the following properties: Tc - 120 K; a = 5.40 ± 0.20 Å, b = 27.0 ± 1.0 Å, c = 36.8 ± 1.0 Å, $\alpha = \beta = \gamma = 90 \pm 1^\circ$ (lattice constant); $2\theta = 4.86 \pm 0.20^\circ$, $2\theta = 24.04 \pm 0.20^\circ$, $2\theta = 26.25 \pm 0.20^\circ$ (peak positions of powder X-ray diffraction pattern using CuKα ray).

FIGURE 2

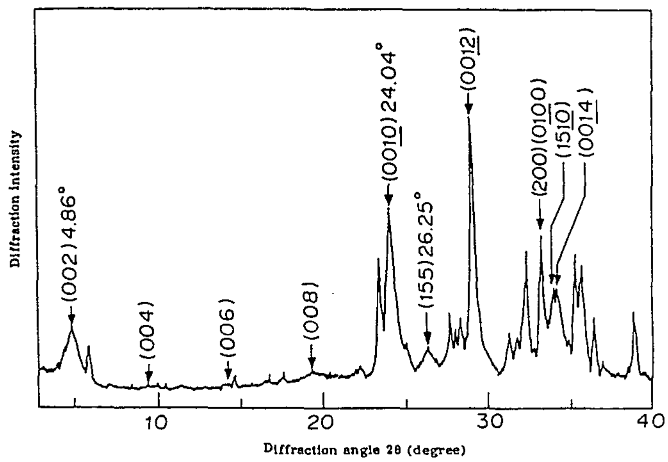

see front page

EA-PCT-7173
Our Ref.: MC-331 (H-89014-PC)

SPECIFICATION

TITLE OF THE INVENTION

OXIDE SUPERCONDUCTOR AND PROCESS FOR ITS PRODUCTION

TECHNICAL FIELD

The present invention relates to an oxide superconductor of Bi system having a high critical temperature (Tc) and a process for its production.

BACKGROUND ART

Researches on superconductors have been conducted on a world-wide scale, since a rare earth type superconductor of 90 K class was reported which is represented by $RBa_2Cu_3O_{7-x}$ (R: rare earth element) and which shows superconductivity at a temperature of at least the liquefying temperature (77 K) of nitrogen. Such superconductors are expected to have a wide range of applications in e.g. the field of power electronics for power storage, transportation or power generation, the weak current electronics field and the scientific and medical fields utilizing high magnetic fields.

However, the transition temperature of this substance for superconductivity was at a level of 90 K although it is higher than 77 K. Therefore, there has been a certain misgiving that so long as inexpensive liquefied nitrogen is used as the cooling medium, it is close to the liquefied nitrogen from the viewpoint of the temperature. Therefore, it has been desired to develop a

superconductor having a Tc as high as at least 120 K i.e. at least 1.5 times the liquefying temperature of nitrogen for the material to be useful as an industrial material. However, a high Tc superconductor of a class exceeding 90 K has not been obtained even by modifying the composition or by substitution of elements of the above-mentioned perovskite type compound which is a superconductor of 90 K class.

On the other hand, with respect to an oxide superconductor of Bi system, an oxide superconductor of Bi-Sr-Cu-O system has been reported by C. Michel et al. (Z. Phys. B-Condensed Matter 68,421-423 (1987)). Although this oxide of Bi-Sr-Cu-O system shows superconductivity, Tc was regrettably as low as about 22 K. Further, it was published on January 21, 1988 that an oxide superconductor of Bi-Sr-Ca-Cu-O system was discovered by H. Maeda et al., and the details were reported in Jpn. J. Appl. Phys. 27 (1988).

DISCLOSURE OF INVENTION

The object of the present invention is to provide an oxide superconductor showing superconductivity at a temperature of at least the liquefying temperature of nitrogen, particularly having a high Tc at a level of 120 K. This object can be accomplished by an oxide superconductor containing strontium, calcium, bismuth and copper, and in some cases, lead, chromium or vanadium, and having a certain specific crystal structure.

Now, the present invention will be described in detail.

The oxide superconductor of the present invention is an oxide containing strontium, calcium, bismuth and copper, and in some cases, lead, chromium or vanadium, whereby the lattice constants representing repeating units of the crystal structure of crystals constituting the substance showing a high Tc at a level of about 120 K, are as follows:

$a = 5.40 \pm 0.20$ Å

$b = 27.0 \pm 1.0$ Å

$c = 36.8 \pm 1.0$ Å

$\alpha = 90 \pm 1°$

$\beta = 90 \pm 1°$

$\gamma = 90 \pm 1°$,

and it has, as measured by X-ray powder diffraction with CuKα radiation (1.5418 Å), diffraction peaks at the following diffraction angles:

$2\theta = 4.86 \pm 0.20°$

$2\theta = 24.04 \pm 0.20°$

$2\theta = 26.25 \pm 0.20°$.

However, it is difficult to obtain the above crystals in a pure state, and the oxide superconductor thereby obtained usually contains impurities. The superconductor of the present invention contains a superconducting material of 120 K in a large amount, whereby as measured by X-ray powder diffraction with CuKα radiation (1.5418

Å), the ratio of the intensity (H) of the diffraction peak at $2\theta = 24.04 \pm 0.20$ specific to a substance having the above-mentioned lattice constants to the intensity (L) of the diffraction peak at $2\theta = 23.29 \pm 0.20°$ specific to a substance having a structure analogous to an Auriillius phase comprising strontium, calcium, bismuth and copper, is $H/L \geqq 0.4$, preferably $H/L \geqq 1.0$, and it has a composition of the following formula:

$Sr_\alpha Ca_\beta Bi_\gamma Cu_\delta O_\varepsilon$

wherein α, β, γ, δ and ε are the numbers of moles of the respective elements, which satisfy:

$0.1 \leqq \alpha/\beta \leqq 1.5$, preferably $0.1 \leqq \alpha/\beta \leqq 0.8$

$0.8 \leqq \alpha/\gamma \leqq 2.0$, preferably $0.8 \leqq \alpha/\gamma \leqq 1.2$

$0.25 \leqq \delta/(\alpha + \beta + \gamma + \delta) \leqq 0.65$, preferably

$0.4 \leqq \delta/(\alpha + \beta + \gamma + \delta) \leqq 0.6$,

or a composition of the following formula:

$Sr_\alpha Ca_\beta Bi_\gamma Cu_\delta X_\varepsilon O_x$

wherein X is lead or chromium, and α, β, γ, δ, ε and x are the numbers of moles of the respective elements, which satisfy:

$\alpha/\beta \leqq 1.0$, $0 < \varepsilon/\beta \leqq 0.6$, preferably $0.1 \leqq \varepsilon/\beta \leqq 0.3$,

$\gamma > 0$, $0.5 \leqq \alpha/(\gamma + \varepsilon) \leqq 1.2$,

$0.25 \leqq \delta/(\alpha + \beta + \gamma + \delta + \varepsilon) \leqq 0.65$,

or a composition of the following formula:

$Sr_\alpha Ca_\beta Bi_\gamma Cu_\delta Pb_\varepsilon O_x$

wherein α, β, γ, δ, ε and x are the numbers of moles of the respective elements, which satisfy:

$\alpha = 2 \pm 0.1$, $\beta = \delta-1$, $\gamma = 2 \pm 0.1$, $4.1 \leqq \delta \leqq 8$,

$0.1 \leqq \varepsilon \leqq 0.6$,

or a composition of the following formula:

$Sr_{\alpha}Ca_{\beta}Bi_{\gamma}Cu_{\delta}Pb_{\varepsilon}O_{x}$

wherein $\alpha$, $\beta$, $\gamma$, $\delta$, $\varepsilon$ and x are the numbers of moles of the respective elements, which satisfy:

$\alpha = 2 \pm 0.1$, $\beta = 3 \pm 0.1$, $\gamma = 2 \pm 0.1$, $\delta = 4 \pm 0.1$,

$0.2 \leqq \varepsilon \leqq 1.0$,

or a composition of the following formula:

$Sr_{\alpha}Ca_{\beta}Bi_{\gamma}Cu_{\delta}Cr_{\varepsilon}O_{x}$

wherein $\alpha$, $\beta$, $\gamma$, $\delta$, $\varepsilon$ and x are the numbers of moles of the respective elements, which satisfy:

$1.8 \leqq \alpha \leqq 2.2$, $1.8 \leqq \beta \leqq 2.2$, $1.0 \leqq \gamma \leqq 2.2$,

$2.7 \leqq \delta \leqq 3.3$, $0.1 \leqq \varepsilon \leqq 1.0$.

or a composition of the formula:

$Sr_{\alpha}Ca_{\beta}Bi_{\gamma}Cu_{\delta}V_{\varepsilon}O_{x}$

wherein $\alpha$, $\beta$, $\gamma$, $\delta$, $\varepsilon$ and x are the numbers of moles of the respective elements, which satisfy:

$1.8 \leqq \alpha \leqq 2.2$, $1.8 \leqq \beta \leqq 2.2$, $\gamma = 2.0-\varepsilon$,

$2.7 \leqq \delta \leqq 3.3$, $0.2 \leqq \varepsilon \leqq 0.8$.

Lead, chromium or vanadium is believed to be substituted for a part of bismuth, and there is no change in the lattice constants of the crystals and in the peaks in the X-ray diffraction by the substitution of such a metal.

According to the analysis of the limited visual field diffraction image by a transmission electron microscope,

a preferred superconductor has layered structural units each comprising an atomic layer composed of strontium, calcium, copper and oxygen, sandwiched between atomic layers composed of bismuth, or bismuth and lead, chromium or vanadium, and oxygen, wherein at least layered structural units having thicknesses of 15.4 ± 1 Å, 18.4 ± 1 Å and 22.5 ± 2 Å are contained in each crystal, and the layered structural units having a thickness of 18.4 ± 1 Å constitute at least 50% of the total layered structural units in each crystal.

The oxide superconductor of the present invention can be prepared by using as starting materials, carbonates, hydroxides, oxides, nitrates, sulfates, oxalates, chlorides or alkoxides, preferably carbonates or oxides, of strontium, calcium, bismuth and copper, and in some cases, lead, chromium or vanadium. Starting materials suitably selected from such starting compounds, are weighed so that the atomic ratio of Sr, Ca, Bi, Cu and, in some cases, Pb, Cr or V, corresponds to the above-mentioned composition and mixed by a conventional method for uniform mixing, such as a powder mixing method, a wet coprecipitation method, an evaporation drying method or an alkoxide method. The resulting mixture is dried. Then, the powder is preferably compression-molded into pellets and calcined to let the solid phase reaction proceed sufficiently.

In the present invention, the superconducting

substance showing a Tc of 120 K (hereinafter referred to simply as a HTc phase) is believed to be $Bi_2Sr_2Ca_2Cu_3O_x$. However, if the blend composition of the starting materials is adjusted to be around Bi : Sr : Ca : Cu = 2 : 2 : 2 : 3 (atomic ratio), the HTc phase is scarecely obtainable, and $Bi_2Sr_2Ca_1Cu_2O_x$ will be formed as a main product, which is a superconducting substance having a Tc of about 80 K (hereinafter referred to simply as a LTc phase). When a mixture of starting materials having a suitable ratio is calcined, $Bi_2Sr_2Cu_1O_x$ having a Tc of about 22 K will be formed at a relatively low temperature at a level of from 500 to 750°C, the LTc phase will be formed at a calcining temperature at a level of from 750 to 820°C, and it is believed that the HTc phase will be formed when calcined at a higher temperature. To obtain the HTc phase with an oxide of Bi-Sr-Ca-Cu system, it is preferred that Ca and Cu, particularly Cu, are present in an excess amount in the mixture of the starting materials, and it is possible to obtain a superconductor having, as measured by X-ray powder diffraction with CuKα radiation (1.5418 Å), diffraction peaks at diffraction angles of $2\theta = 4.9 \pm 0.2°$, $2\theta = 24.1 \pm 0.2°$ and $2\theta = 26.3 \pm 0.2°$, by calcining a mixture of starting materials to obtain an oxide having a composition of the following formula:

$$Sr_\alpha Ca_\beta Bi_\gamma Cu_\delta O_x$$

wherein α, β, γ, δ and x are the numbers of moles of the

respective elements, which satisfy:

$\alpha/\beta \leqq 1.0,\ 0.8 \leqq \alpha/\gamma \leqq 1.2,\ 0.45 \leqq \delta/(\alpha + \beta + \gamma + \delta) \leqq 0.8,$

or a composition of the following formula:

$Sr_\alpha Ca_\beta Bi_\gamma Cu_\delta O_x$

wherein $\alpha$, $\beta$, $\gamma$, $\delta$ and x are the numbers of moles of the respective elements, which satisfy:

$\alpha/\beta \leqq 0.8,\ 0.8 \leqq \alpha/\gamma \leqq 1.2,\ 0.35 \leqq \delta/(\alpha + \beta + \gamma + \delta) \leqq 0.65.$

In the above-mentioned composition of starting materials, copper is contained in an excess amount, and the resulting superconducting material tends to have a high content of impurities such as CuO and $CaCuO_3$. However, by adding lead, chromium or vanadium to the composition of strontium, calcium, bismuth and copper, it is possible to bring the composition of starting materials closer to the atomic ratio of the HTc phase, and it is possible to produce a stable superconductor by calcination at a relatively low temperature.

The calcination is conducted in two steps. The first calcination is conducted usually at a temperature of at least 500°C to decompose various salts. Since the melting point of bismuth oxide is 825°C, the first calcination is conducted at a temperature of not higher than 820°C, preferably from 750 to 820°C, whereby by the formation of a compound oxide, bismuth oxide will no longer be observed, and then the second calcination is

conducted. When a vanadium compound is contained in the starting materials, the first calcination is conducted at a temperature of not higher than 680°C, since the melting point of vanadium oxide is 690°C, whereby by the formation of a compound oxide, vanadium oxide will no longer be observed, and then the second calcination is conducted. The disappearance of bismuth oxide or vanadium oxide can be detected by the X-ray diffraction. The second calcination is conducted at a temperature of at least 830°C, preferably from 840 to 880°C. The optimum calcining temperature varies depending upon the constituting components. Namely, the second calcination is conducted at a temperature of from 865 to 880°C in the case of a four component system comprising strontium, calcium, bismuth and copper, at a temperature of from 840 to 855°C in the case of a system prepared by adding lead or chromium to the above-mentioned four components, and at a temperature of from 855 to 865°C in the case of a system prepared by adding vanadium to the above-mentioned four components. It is necessary to conduct the second calcination for at least one hour, preferably at least 24 hours, more preferably at least 120 hours. The longer the calcining time is, the better the superconducting properties of the superconductor become. However, if the calcination is conducted at a temperature exceeding 880°C, the superconducting properties tend to deteriorate as the calcining temperature is prolonged, and in some

cases, the product no longer exhibits superconductivity. It is therefore necessary to take a due care. If necessary, after the second calcination, the superconducting substance of 120 K may be extracted and purified and then subjected to a third calcination. Such a second calcination or a third calcination is particularly effective when conducted in an atmosphere with the oxygen concentration enriched over atmospheric air. Namely, it is possible to improve the purity of the HTc phase in the resulting superconductor by the calcination in an atmosphere having an oxygen concentration of from 40 to 100% by volume, particularly from 90 to 100% by volume, at a temperature of from 850 to 875°C.

The compound oxide thus obtained is analysed for the superconducting properties such as the electric resistance or the temperature dependency of the AC complex magnetic susceptibility, whereby it can be confirmed to be an oxide superconductor having a Tc of about 120 K.

BRIEF DESCRIPTION OF THE DRAWINGS

Figure 1 is a pattern of X-ray powder diffraction of the superconductor prepared in Example 1, as measured by means of CuKα radiation (1.5418 Å).

Figure 2 is a pattern of X-ray powder diffraction of the superconductor prepared in Example 20, as measured by means of CuKα radiation (1.5418 Å). The diffraction

peaks identified with face indices are the diffraction peaks of the superconducting substance of 120 K, and others are diffraction peaks attributable to impurities or to a substance having a structure analogous to an Auriillius phase.

Figure 3 is an enlarged view of a portion of Figure 2 at the diffraction angle (2θ) of about 23 to 24°, and H and L indicate the intensities of the diffraction peaks at $2\theta = 24.04°$ and $2\theta = 23.29°$, respectively.

Figure 4 is a pattern of X-ray powder diffraction of the superconductor prepared in Example 26, as measured by means of CuKα radiation (1.5418 Å). The diffraction peaks identified with face indices are the diffraction peaks of the superconducting substance of 120 K.

Figure 5 shows the results of the measurement of the temperature dependency of the AC complex magnetic susceptibility, of the superconductor prepared in Example 26.

Figures 6 and 7 are patterns of X-ray powder diffraction of the superconductor prepared in Example 27 and of the heat treated product of the superconductor, as measured by means of CuKα radiation (1.5418 Å).

Figure 8 is a pattern of X-ray powder diffraction of the superconductor prepared in Example 70, as measured by means of CuKα radiation (1.5418 Å).

Figure 9 is a view illustrating an example of the superconducting properties (the temperature dependency of

the electrical resistivity) of the superconductor of the present invention.

Figure 10 is a view illustrating an example of the supercondcting properties (the temperature dependency of the AC complex magnetic susceptibility) of the superconductor of the present invention.

BEST MODE FOR CARRYING OUT THE INVENTION

Now, the present invention will be described in further detail with reference to Examples. However, it should be understood that the present invention is by no means restricted by the following Examples.

EXAMPLE 1

0.4927 g of strontium carbonate, 0.6680 g of calcium carbonate, 0.7775 g of bismuth (III) oxide and 1.0618 g of copper (II) oxide (powders having a purity of at least 99.9%, respectively, manufactured by Koujundo Kagaku-sha) were put in an agate mortar, and ethanol was added in an amount of about 1 mℓ, and the mixture was slurried and thoroughly stirred for mixing, and then it was pulverized and mixed for about 30 minutes until ethanol odor diminished. The atomic ratio of Sr, Ca, Bi and Cu in the mixture was 12.5 : 25.0 : 12.5 : 50.0.

0.4 g of the powder mixture thus obtained was compression-molded (1 ton/$cm^2$) by a usual method to obtain pellets having a diameter of 10 mm. The pellets were subjected to first calcination in air at 800°C for 5 hours and then two second calcination at 880°C for 9

hours.

The temperature dependency of the electrical resistivity and the AC complex magnetic susceptibility of the calcined product thus obtained were measured, whereby it was confirmed that this substance reached a critical temperature at 120 K and thus was a superconducting substance of 120 K class.

By using the following formulas, ΔR(%) and ΔX(%) were determined and presented in Table 2.

$$\Delta R = 100 \times R_1/(R_1 + R_2)$$

In the above formula, $R_1$ is the value of abnormal drop of the electrical resistivity at the time of Tc onset at about 120 K and $R_2$ is the value of abnormal drop of the electrical resistivity at the time of Tc end, as illustrated in Figure 9.

$$\Delta X = 100 \times X_1/(X_1 + X_2)$$

In the above formula, $X_1$ is the value of change of the magnetic susceptibility showing diamagnetic susceptibility at a temperature of about 120 K and $X_2$ is the value of change of the magnetic susceptibility at a temperature of not higher than the temperature where a shoulder appears when the shoulder is present at a temperature of from 75 to 90 K, as illustrated in Figure 10.

As a result of the X-ray powder diffraction of the superconductor of the present invention with CuKα radiation (1.5418 Å), a group of diffraction peaks

attributable to a novel substance was observed at $2\theta = 4.8°$, $2\theta = 24.1°$ and $2\theta = 26.3°$, as shown in Figure 1.

EXAMPLES 2 TO 19 AND 28 TO 46

Oxide superconductors were prepared in the same manner as in Example 1 except that the atomic ratio of Sr, Ca, Bi and Cu was changed as shown in Tables 2 and 3, whereupon $\Delta R$ or $\Delta X$ was measured. The results thereby obtained are shown in Tables 2 and 3.

EXAMPLES 20

An oxide superconductor was prepared in the same manner as in Example 1 except that the atomic ratio of Sr, Ca, Bi and Cu was changed as shown in Table 2, the firtst calcination was conducted at 800°C for 24 hours, and the second calcination was conducted at 870°C for 24 hours.

The temperature dependency of the electrical resistivity and the AC complex magnetic susceptibility of the calcined product were measured, whereby $\Delta X$ was 100%, and the substance reached a critical temperature at 120 K and was found to be a superconductor of 120 K class.

As a result of the X-ray powder diffraction of the substance with CuKα radiation (1.5418 Å), a group of diffraction peaks attributable to a novel substance was observed at $2\theta = 4.86°$, $2\theta = 24.04°$ and $2\theta = 26.25°$ and at other angles in a mixed state with diffraction peaks attributable to impurities and to a substance having a

structure analogous to an Auriillius phase, as shown in Figure 2. Further, with respect to the substance showing such a group of diffraction peaks, the limited visual field diffraction image was observed by a transmission electron microscope, whereby a periodical structure with 1.851 $nm^{-1}$ in the $a^*$ axis direction, 0.370 $nm^{-1}$ in the $b^*$ axis direction and 0.271 $nm^{-1}$ in the $c^*$ axis direction was observed. A structural analysis was conducted on the basis of a diffraction spot where the $a^*$ axis, the $b^*$ axis and the $c^*$ axis cross substantially at right angles to one another, whereby Miller indices were applied to the above group of diffraction peaks as shown in Table 1 and Figure 2, and the lattice constants representing repeating units of the crystal structure of this substance were as follows:

$a = 5.40 \pm 0.20$ Å  $\alpha = 90 \pm 1°$

$b = 27.0 \pm 1.0$ Å  $\beta = 90 \pm 1°$

$c = 36.8 \pm 1.0$ Å  $\gamma = 90 \pm 1°$

To compare the volume ratio of the substance having the above crystal structure, the ratio of the intensity (H in Figure 3) of the diffraction peak at $2\theta = 24.04 \pm 0.20°$ specific to the substance having the above-mentioned lattice constants to the intensity (L in Figure 3) of the diffraction peak at $2\theta = 23.29 \pm 0.20°$ specific to the substance having a structure analogous to an Auriillius phase comprising Sr, Ca, Bi and Cu, was calculated, whereby H/L = 2.0, and thus it was confirmed

that the HTc phase was the main component.

Table 1

| Diffraction angle (2θ) | | Miller indices (abc) |
|---|---|---|
| Found | Calculated | |
| 4.86 | 4.79 | 002 |
| 9.62 | 9.60 | 004 |
| 14.50 | 14.42 | 006 |
| 19.17 | 19.26 | 008 |
| 24.04 | 24.14 | 0010 |
| 26.25 | 26.26 | 155 |
| 29.02 | 29.07 | 0012 |
| 33.13 | 33.13 | 200 |
| | | 0100 |
| 33.79 | 33.77 | 1510 |
| 34.07 | 34.05 | 0014 |

EXAMPLES 21 TO 25 AND 47 TO 50

Oxide superconductors were prepared in the same manner as in Example 20 except that the atomic ratio of Sr, Ca, Bi and Cu was changed as identified in Tables 2 and 3, whereupon H/L and ΔX were measured. The results thereby obtained are shown in Tables 2 and 3.

EXAMPLE 26

An oxide superconductor was prepared in the same manner as in Example 20 except that the atomic ratio of Sr, Ca, Bi and Cu was changed as identified in Table 2, and the second calcination was conducted at 870°C for 120 hours. As a result of the X-ray powder diffraction of the oxide thus obtained with CuKα radiation (1.5418 Å), a group of diffraction peaks attributable to a new substance was observed at $2\theta = 4.86°$, $2\theta = 24.04°$ and $2\theta = 26.25°$ and at other angles in a mixed state with diffraction peaks attributable to impurities and to a substance having a structure analogous to an Auriillius phase, as shown in Figure 4. In the X-ray powder diffraction of this oxide, no diffraction peak appeared at $2\theta = 23.29° \pm 0.2°$, and H/L was ∞.

With respect to the substance showing the above diffraction peaks, the lattice image was observed by a high-resolution transmission electron microscope, whereby a number of layered structural units each comprising an atomic layer composed of strontium, calcium, copper and oxygen, sandwiched between atomic layers composed of

bismuth and oxygen, were observed. In each crystal, layered structural units having thicknesses of 15.4 ± 1 Å, 18.4 ± 1 Å and 22.5 ± 2 Å were present in a mixed state, and the layered structural unit having a thickness of 18.4 ± 1 Å was observed to be present in an amount of at least 50% relative to the total structural units in each crystal.

Further, as a result of the measurement of the temperature dependency of the AC complex magnetic susceptibility, the superconductor reached a critical temperature at 120 K, as shown in Figure 5.

EXAMPLE 27

An oxide superconductor was prepared in the same manner as in Example 20 except that the atomic ratio of Sr, Ca, Bi and Cu was changed as identified in Table 2, and after the calcination, the product was gradually cooled to room temperature at a temperature lowering rate of 50°C/hr. The results of the X-ray powder diffraction of the sintered product thus obtained, with CuKα radiation (1.5418 Å), are shown in Figure 7. Further, H/L was 1.4. A powder of this oxide superconductor was subjected to heat treatment at 850°C or 870°C for 5 hours in atmospheres having various oxygen concentrations as identified Table 4. The temperature raising and the temperature lowering were conducted at a rate of 20°C/hr. The H/L of the oxide superconductor subjected to heat

treatment, was measured, whereby the results as identified in Table 4 were obtained. The results of the X-ray powder diffraction of the superconductor obtained in Example 27-1, with CuKα radiation (1.5418 Å), are shown in Figure 8.

Table 2 (Examples)

| Example Nos. | Atomic ratio | | | | First calcination | | Second calcination | | H/L | ΔX (%) | ΔR (%) |
|---|---|---|---|---|---|---|---|---|---|---|---|
| | Sr | Ca | Bi | Cu | °C | Hr | °C | Hr | | | |
| 1 | 12.5 | 25.0 | 12.5 | 50.0 | 800 | 5 | 880 | 9 | | 100 | 100 |
| 2 | 10.0 | 30.0 | 10.0 | 50.0 | 800 | 5 | 880 | 9 | | 100 | 100 |
| 3 | 13.3 | 23.4 | 13.3 | 50.0 | 800 | 5 | 880 | 9 | | | 95 |
| 4 | 15.0 | 20.0 | 15.0 | 50.0 | 800 | 5 | 880 | 9 | | | 83 |
| 5 | 16.7 | 16.7 | 16.7 | 50.0 | 800 | 5 | 880 | 9 | | | 63 |
| 6 | 18.0 | 18.0 | 19.0 | 45.0 | 800 | 5 | 880 | 9 | | | 70 |
| 7 | 17.0 | 21.0 | 17.0 | 45.0 | 800 | 5 | 880 | 9 | | | 78 |
| 8 | 15.0 | 25.0 | 15.0 | 45.0 | 800 | 5 | 880 | 9 | | | 83 |
| 9 | 13.0 | 29.0 | 13.0 | 45.0 | 800 | 5 | 880 | 9 | | 100 | 84 |
| 10 | 11.0 | 33.0 | 11.0 | 45.0 | 800 | 5 | 880 | 9 | | 100 | |
| 11 | 7.5 | 35.0 | 7.5 | 50.0 | 800 | 5 | 880 | 9 | | 100 | |

Table 2 (Examples) (continued)

| Example Nos. | Atomic ratio | | | | First calcination | | Second calcination | | H/L | ΔX (%) | ΔR (%) |
|---|---|---|---|---|---|---|---|---|---|---|---|
| | Sr | Ca | Bi | Cu | °C | Hr | °C | Hr | | | |
| 12 | 5.0 | 40.0 | 5.0 | 50.0 | 800 | 5 | 880 | 9 | | 100 | |
| 13 | 8.25 | 38.5 | 8.25 | 45.0 | 800 | 5 | 880 | 9 | | 100 | |
| 14 | 5.5 | 44.0 | 5.5 | 45.0 | 800 | 5 | 880 | 9 | | 100 | |
| 15 | 9.0 | 42.0 | 9.0 | 40.0 | 800 | 5 | 880 | 9 | | 100 | |
| 16 | 12.0 | 36.0 | 12.0 | 40.0 | 800 | 5 | 880 | 9 | | 100 | |
| 17 | 15.0 | 30.0 | 15.0 | 40.0 | 800 | 5 | 880 | 9 | | 100 | |
| 18 | 16.5 | 22.0 | 16.5 | 45.0 | 800 | 5 | 880 | 9 | | 50 | |
| 19 | 16.5 | 22.0 | 16.5 | 45.0 | 800 | 5 | 880 | 1 | | 80 | |
| 20 | 13.0 | 29.0 | 13.0 | 45.0 | 800 | 24 | 870 | 24 | 2.0 | 100 | |
| 21 | 12.5 | 25.0 | 12.5 | 50.0 | 800 | 24 | 870 | 24 | 1.2 | 100 | |
| 22 | 10.0 | 30.0 | 10.0 | 50.0 | 800 | 24 | 870 | 24 | 4.9 | 100 | |
| 23 | 16.5 | 22.0 | 16.5 | 45.0 | 800 | 24 | 870 | 24 | 0.4 | 80 | |

Table 2 (Examples) (continued)

| Example Nos. | Atomic ratio | | | | First calcination | | Second calcination | | H/L | ΔX (%) | ΔR (%) |
|---|---|---|---|---|---|---|---|---|---|---|---|
| | Sr | Ca | Bi | Cu | °C | Hr | °C | Hr | | | |
| 24 | 15.0 | 30.0 | 15.0 | 40.0 | 800 | 24 | 870 | 24 | 1.0 | 100 | |
| 25 | 12.0 | 36.0 | 12.0 | 40.0 | 800 | 24 | 870 | 24 | 6.5 | 100 | |
| 26 | 11.1 | 33.3 | 11.1 | 44.5 | 800 | 24 | 870 | 120 | ∞ | | |
| 27 | 11.0 | 33.0 | 11.0 | 45.0 | 800 | 24 | 870 | 24 | 1.4 | | |

Table 3 (Comparative Examples)

| Example Nos. | Atomic ratio | | | | First calcination | | Second calcination | | H/L | ΔX (%) | ΔR (%) |
|---|---|---|---|---|---|---|---|---|---|---|---|
| | Sr | Ca | Bi | Cu | °C | Hr | °C | Hr | | | |
| 28 | 20.0 | 20.0 | 20.0 | 40.0 | 800 | 5 | 880 | 9 | | | 50 |
| 29 | 30.0 | 20.0 | 10.0 | 40.0 | 800 | 5 | 880 | 9 | | | 5 |
| 30 | 20.0 | 30.0 | 10.0 | 40.0 | 800 | 5 | 880 | 9 | | | 2 |
| 31 | 30.0 | 15.0 | 15.0 | 40.0 | 800 | 5 | 880 | 9 | | | 1 |
| 32 | 30.0 | 10.0 | 20.0 | 40.0 | 800 | 5 | 880 | 9 | | | 1 |
| 33 | 20.0 | 20.0 | 10.0 | 50.0 | 800 | 5 | 880 | 9 | | | 5 |
| 34 | 20.0 | 10.0 | 20.0 | 50.0 | 800 | 5 | 880 | 9 | | | 2 |
| 35 | 10.0 | 20.0 | 20.0 | 50.0 | 800 | 5 | 880 | 9 | | | 5 |
| 36 | 25.0 | 25.0 | 25.0 | 25.0 | 800 | 5 | 880 | 9 | | | 1 |
| 37 | 20.0 | 30.0 | 20.0 | 30.0 | 800 | 5 | 880 | 9 | | | 20 |
| 38 | 35.0 | 15.0 | 15.0 | 35.0 | 800 | 5 | 880 | 9 | | | 5 |

Table 3 (Comparative Examples) (continued)

| Example Nos. | Atomic ratio | | | | First calcination | | Second calcination | | H/L | ΔX (%) | ΔR (%) |
|---|---|---|---|---|---|---|---|---|---|---|---|
| | Sr | Ca | Bi | Cu | °C | Hr | °C | Hr | | | |
| 39 | 30.0 | 20.0 | 20.0 | 30.0 | 800 | 5 | 880 | 9 | | | 2 |
| 40 | 20.0 | 20.0 | 30.0 | 30.0 | 800 | 5 | 880 | 9 | | | 25 |
| 41 | 60.0 | 6.0 | 6.0 | 28.0 | 800 | 5 | 880 | 9 | | – | – |
| 42 | 54.0 | 12.0 | 6.0 | 28.0 | 800 | 5 | 880 | 9 | | | – |
| 43 | 54.0 | 6.0 | 6.0 | 34.0 | 800 | 5 | 880 | 9 | | – | – |
| 44 | 29.0 | 5.0 | 16.0 | 50.0 | 800 | 5 | 880 | 9 | | – | – |
| 45 | 45.0 | 5.0 | 5.0 | 45.0 | 800 | 5 | 880 | 9 | | – | – |
| 46 | 40.0 | 5.0 | 5.0 | 50.0 | 800 | 5 | 880 | 9 | | – | – |
| 47 | 29.0 | 5.0 | 16.0 | 50.0 | 800 | 24 | 870 | 24 | 0 | 0 | |
| 48 | 45.0 | 5.0 | 5.0 | 45.0 | 800 | 24 | 870 | 24 | 0 | 0 | |
| 49 | 20.0 | 20.0 | 20.0 | 40.0 | 800 | 24 | 870 | 24 | 0.04 | 38 | |
| 50 | 60.0 | 6.0 | 6.0 | 28.0 | 800 | 24 | 870 | 24 | 0 | 0 | |

Table 4

| Example Nos. | Oxygen concentration (vol%) | Heating temperature (°C) | H/L |
|---|---|---|---|
| 27-1 | 96 | 870 | 5.6 |
| 27-2 | 96 | 850 | 2.0 |
| 27-3 | 40 | 870 | 1.6 |
| 27-4 | 40 | 850 | 1.5 |
| 27-5 | 20 | 870 | 1.4 |
| 27-6 | 10 | 870 | 0.0 |

EXAMPLE 51

0.4943 g of strontium carbonate, 0.6702 g of calcium carbonate, 0.5460 g of bismuth (III) oxide and 1.0652 g of copper (II) oxide and 0.2242 g of lead oxide (powders having a purity of at least 99.9%, respectively, manufactured by Koujundo Kagaku-sha) were put in an agate mortar, and ethanol was added in an amount of about 1 mℓ. The mixture was slurried and thoroughly stirred for mixing until ethanol odor diminished. The atomic ratio of Sr, Ca, Bi, Cu and Pb in the mixture was 12.5 : 25.0 : 8.75 : 50.0 : 3.75.

0.4 g of the powder mixture thus obtained was compression-molded (1 ton/$cm^2$) by a usual method to obtain pellets having a diameter of 10 mm. The pellets

were subjected to first calcination in air at 800°C for 24 hours and then to second calcination at 850°C for 24 hours.

The temperature dependency of the electrical resistivity and the AC complex magnetic susceptibility of the calcined product thus obtained, were measured, whereby the substance reached a critical temperature at 120 K and was thus found to be a superconductor of 120 K class. ΔR(%) is shown in Table 5.

EXAMPLES 52 TO 69 AND 81 TO 88

Oxide superconductors were prepared in the same manner as in Example 51 except that the atomic ratio of Sr, Ca, Bi, Cu and Pb was changed as identified in Tables 5 and 6, whereupon ΔR or H/L was measured. The results thereby obtained are shown in Tables 5 and 6.

EXAMPLE 70

0.7946 g of strontium carbonate, 0.5387 g of calcium carbonate, 0.8777 g of bismuth (III) oxide, 0.6421 g of copper (II) oxide and 0.1468 g of vanadium (V) oxide (powders having a purity of at least 99.9%, respectively, manufactured by Koujundo Kagaku-sha) were put in an agate mortar, and ethanol was added in an amount of about 1 mm. The mixture was slurried and thoroughly stirred for mixing until ethanol odor diminished. The atomic ratio of Sr, Ca, Bi, Cu and V in the mixture was 2.0 : 2.0 : 1.4 : 3.0 : 0.6.

0.4 g of the powder mixture thus obtained was

compression-molded (1 ton/$cm^2$) by a usual method to obtain pellets having a diameter of 10 mm. The pellets were subjected to first calcination in air at 600°C for 24 hours and then to second calcination at 860°C for 24 hours, and then gradually cooled to room temperature at a temperature lowering rate of 50°C/hr.

The temperature dependency of the electrical resistivity and the AC complex magnetic susceptibility of the calcined product thus obtained, were measured, whereby the substance reached a critical temperature at 120 K and was found to be a superconductor of 110 K class. The results of the X-ray powder diffraction of this oxide superconductor, with CuKα radiation (1.5418 Å), are shown in Figure 8. Further, the results of the measurement of H/L are shown in Table 5.

EXAMPLES 71 TO 74 AND 89 TO 94

Oxide superconductors were prepared in the same manner as in Example 70 except that the atomic ratio of Sr, Ca, Bi, Cu and V was changed as identified in Tables 5 and 6, whereupon H/L was measured. The results thereby obtained are shown in Tables 5 and 6.

EXAMPLE 75

0.7789 g of strontium carbonate, 0.5281 g of calcium carbonate, 0.9833 g of bismuth (III) oxide, 0.6295 g of copper (II) oxide and 0.0802 g of chromium (V) oxide (powders having a purity of at least 99.9%, respectively, manufactured by Koujundo Kagaku-sha) were put in an agate

mortar, and ethanol was added in an amount of about 1 mℓ. The mixture was slurried and thoroughly stirred for mixing until ethanol odor diminished. The atomic ratio of Sr, Ca, Bi, Cu and Cr in the mixture was 2.0 : 2.0 : 1.6 : 3.0 : 0.4.

0.4 g of the powder mixture thus obtained was compression-molded (1 ton/$cm^2$) by a usual method to obtain pellets having a diameter of 10 mm. The pellets were subjected to first calcination in air at 800°C for 5 hours and then to second calcination at 850°C for 24 hours.

The temperature dependency of the electrical resistivity and the AC complex magnetic susceptibility of the calcined product thus obtained, were measured, whereby the substance reached a critical temperature at 120 K and was thus found to be a superconductor of 110 K class. The results of the measurement of H/L of this oxide superconductor are shown in Table 5.

EXAMPLES 76 TO 80 AND 95 TO 96

Oxide superconductors were prepared in the same manner as in Example 75 except that the atomic ratio of Sr, Ca, Bi, Cu and Cr was changed as identified in Tables 5 and 6, whereupon H/L was measured. The results thereby obtained are shown in Tables 5 and 6.

Table 5 (Examples)

| Example Nos. | Atomic ratio | | | | | X | First calcination | | Second calcination | | H/L | ΔR(%) |
|---|---|---|---|---|---|---|---|---|---|---|---|---|
| | Sr | Ca | Bi | Cu | X | | °C | Hr | °C | Hr | | |
| 51 | 2.0 | 4.0 | 1.4 | 8.0 | 0.6 | Pb | 800 | 24 | 850 | 24 | | 100 |
| 52 | 2.0 | 3.2 | 2.0 | 8.0 | 0.8 | Pb | 800 | 24 | 850 | 24 | | 100 |
| 53 | 2.0 | 4.0 | 1.6 | 8.0 | 0.4 | Pb | 800 | 24 | 850 | 24 | | 100 |
| 54 | 2.0 | 3.6 | 2.0 | 8.0 | 0.4 | Pb | 800 | 24 | 850 | 24 | | 53 |
| 55 | 2.0 | 4.0 | 1.8 | 8.0 | 0.2 | Pb | 800 | 24 | 850 | 24 | | 40 |
| 56 | 1.4 | 4.0 | 2.0 | 8.0 | 0.6 | Pb | 800 | 24 | 850 | 24 | | 30 |
| 57 | 2.0 | 7.0 | 2.0 | 8.0 | 0.3 | Pb | 800 | 24 | 850 | 24 | 6.8 | |
| 58 | 2.0 | 5.0 | 2.0 | 6.0 | 0.3 | Pb | 800 | 24 | 850 | 24 | 4.5 | |
| 59 | 2.0 | 4.0 | 2.0 | 5.0 | 0.3 | Pb | 800 | 24 | 850 | 24 | 4.5 | |
| 60 | 2.0 | 7.0 | 2.0 | 8.0 | 0.16 | Pb | 800 | 24 | 850 | 24 | 4.4 | |
| 61 | 2.0 | 5.0 | 2.0 | 6.0 | 0.38 | Pb | 800 | 24 | 850 | 24 | 4.2 | |
| 62 | 2.0 | 3.0 | 2.0 | 4.0 | 0.8 | Pb | 800 | 24 | 850 | 24 | 4.1 | |
| 63 | 2.0 | 3.0 | 2.0 | 4.0 | 0.3 | Pb | 800 | 24 | 850 | 24 | 3.1 | |
| 64 | 2.0 | 7.0 | 2.0 | 8.0 | 0.38 | Pb | 800 | 24 | 850 | 24 | 3.0 | |
| 65 | 2.0 | 3.0 | 2.0 | 4.0 | 0.38 | Pb | 800 | 24 | 850 | 24 | 2.6 | |

Table 5 (Examples) (continued)

| Example Nos. | Atomic ratio | | | | | X | First calcination | | Second calcination | | H/L | ΔR(%) |
|---|---|---|---|---|---|---|---|---|---|---|---|---|
| | Sr | Ca | Bi | Cu | X | | °C | Hr | °C | Hr | | |
| 66 | 2.0 | 3.0 | 2.0 | 4.0 | 0.64 | Pb | 800 | 24 | 850 | 24 | 2.6 | |
| 67 | 2.0 | 5.0 | 2.0 | 6.0 | 0.16 | Pb | 800 | 24 | 850 | 24 | 2.5 | |
| 68 | 2.0 | 4.0 | 2.0 | 5.0 | 0.16 | Pb | 800 | 24 | 850 | 24 | 2.4 | |
| 69 | 2.0 | 4.0 | 2.0 | 5.0 | 0.38 | Pb | 800 | 24 | 850 | 24 | 2.1 | |
| 70 | 2.0 | 2.0 | 1.4 | 3.0 | 0.6 | V | 600 | 24 | 860 | 24 | 2.7 | |
| 71 | 2.0 | 2.0 | 1.6 | 3.0 | 0.4 | V | 600 | 24 | 860 | 24 | 0.5 | |
| 72 | 1.8 | 1.8 | 1.8 | 2.7 | 0.2 | V | 600 | 24 | 860 | 24 | 0.3 | |
| 73 | 2.0 | 2.0 | 1.8 | 3.0 | 0.2 | V | 600 | 24 | 860 | 24 | 0.2 | |
| 74 | 2.0 | 2.0 | 1.2 | 3.0 | 0.8 | V | 600 | 24 | 860 | 24 | 0.1 | |
| 75 | 2.0 | 2.0 | 1.6 | 3.0 | 0.4 | Cr | 800 | 5 | 850 | 24 | ∞ | |
| 76 | 2.0 | 2.0 | 1.5 | 3.0 | 0.5 | Cr | 800 | 5 | 850 | 24 | 4.0 | |
| 77 | 2.0 | 2.0 | 1.4 | 3.0 | 0.6 | Cr | 800 | 5 | 850 | 24 | 3.0 | |
| 78 | 2.0 | 2.0 | 2.0 | 3.0 | 0.4 | Cr | 800 | 5 | 850 | 24 | 6.0 | |
| 79 | 2.0 | 2.0 | 2.0 | 3.0 | 0.5 | Cr | 800 | 5 | 850 | 24 | 3.0 | |
| 80 | 2.0 | 2.0 | 2.0 | 3.0 | 0.6 | Cr | 800 | 5 | 850 | 24 | 2.0 | |

Table 6 (Comparative Examples)

| Example Nos. | Atomic ratio | | | | | X | First calcination | | Second calcination | | H/L | ΔR(%) |
|---|---|---|---|---|---|---|---|---|---|---|---|---|
| | Sr | Ca | Bi | Cu | X | | °C | Hr | °C | Hr | | |
| 81 | 2.0 | 4.0 | 0 | 8.0 | 2.0 | Pb | 800 | 24 | 850 | 24 | | – |
| 82 | 1.2 | 4.0 | 2.0 | 8.0 | 0.8 | Pb | 800 | 24 | 850 | 24 | | 0 |
| 83 | 2.0 | 2.4 | 2.0 | 8.0 | 1.6 | Pb | 800 | 24 | 850 | 24 | | 0 |
| 84 | 2.0 | 2.0 | 2.0 | 3.0 | 0 | Pb | 800 | 24 | 850 | 24 | 0 | |
| 85 | 2.0 | 3.0 | 2.0 | 4.0 | 0 | Pb | 800 | 24 | 850 | 24 | 0 | |
| 86 | 2.0 | 4.0 | 2.0 | 5.0 | 0 | Pb | 800 | 24 | 850 | 24 | 0 | |
| 87 | 2.0 | 5.0 | 2.0 | 6.0 | 0 | Pb | 800 | 24 | 850 | 24 | 0 | |
| 88 | 2.0 | 7.0 | 2.0 | 8.0 | 0 | Pb | 800 | 24 | 850 | 24 | 0.1 | |
| 89 | 2.0 | 2.0 | 2.0 | 3.0 | 0 | V | 600 | 24 | 860 | 24 | 0 | |
| 90 | 2.0 | 2.0 | 1.0 | 3.0 | 1.0 | V | 600 | 24 | 860 | 24 | 0 | |
| 91 | 2.0 | 2.0 | 2.0 | 3.0 | 0.4 | V | 600 | 24 | 860 | 24 | 0 | |
| 92 | 2.0 | 2.0 | 2.0 | 3.0 | 0.6 | V | 600 | 24 | 860 | 24 | 0 | |
| 93 | 2.0 | 2.0 | 2.0 | 3.0 | 0.8 | V | 600 | 24 | 860 | 24 | 0 | |
| 94 | 2.0 | 2.0 | 2.0 | 3.0 | 1.0 | V | 600 | 24 | 860 | 24 | 0 | |
| 95 | 2.0 | 2.0 | 2.0 | 3.0 | 0 | Cr | 800 | 5 | 850 | 24 | 0 | |
| 96 | 2.0 | 3.0 | 2.0 | 4.0 | 0 | Cr | 800 | 5 | 850 | 24 | 0 | |

CLAIM(S):

1. An oxide superconductor having a composition of the formula:

$Sr_\alpha Ca_\beta Bi_\gamma Cu_\delta O_x$

wherein, α, β, γ, δ and x are the numbers of moles of the respective elements, which satisfy:

$0.1 \leqq \alpha/\beta \leqq 1.5$

$0.8 \leqq \alpha/\gamma \leqq 2.0$

$0.25 \leqq \delta/(\alpha + \beta + \gamma + \delta) \leqq 0.65$

whereby, as measured by X-ray powder diffraction with CuKα radiation (1.5418 Å), the ratio of the intensity (H) of the diffraction peak at 2θ = 24.04 ± 0.20° to the intensity (L) of the diffraction peak at 2θ = 23.29 ± 0.20° specific to a substance having a structure analogous to an Auriillius phase comprising strontium, calcium, bismuth and copper, is:

$H/L \geqq 0.4.$

2. An oxide superconductor made of an oxide containing strontium, calcium, bismuth and copper elements and having, as measured by X-ray powder diffraction with CuKα radiation (1.5418 Å), diffraction peaks at the following diffraction angles:

2θ = 4.86 ± 0.20°

2θ = 24.04 ± 0.20°

2θ = 26.25 ± 0.20°

whereby, as measured by the same X-ray powder diffraction, the ratio of the intensity (H) of the

diffration peak at 2θ = 24.04 ± 0.20° to the intensity (L) of the diffraction peak at 2θ = 23.29 ± 0.20° specific to the substance having a structure analogous to an Auriillius phase comprising the above four elements, is:

$H/L \geqq 0.4$.

3. An oxide superconductor made of an oxide containing strontium, calcium, bismuth and copper elements and containing a substance having a crystal structure with the following lattice constants representing repeating units of the crystal structure:

a = 5.40 ± 0.20 Å

b = 27.0 ± 1.0 Å

c = 36.8 ± 1.0 Å

α = 90 ± 1°

β = 90 ± 1°

γ = 90 ± 1°

whereby, as measured by X-ray powder diffraction with CuKα radiation (1.5418 Å), the ratio of the intensity (H) of the diffraction peak at 2θ = 24.04 ± 0.20° to the intensity (L) of the diffraction peak at 2θ = 23.29 ± 0.20° specific to a substance having a structure analogous to an Auriillius phase containing the above four elements, is:

$H/L \geqq 0.4$.

4. An oxide superconductor made of an oxide containing strontium, calcium, bismuth and copper elements and

having layered structural units each comprising an atomic layer composed of strontium, calcium, copper and oxygen, sandwiched between atomic layers composed of bismuth and oxygen, wherein at least layered structural units having thicknesses of 15.4 ± 1 Å, 18.4 ± 1 Å and 22.5 ± 2 Å are contained in each crystal, and the layered structural units having a thickness of 18.4 ± 1 Å constitute at least 50% of the total layered structural units in each crystal.

5. The oxide superconductor according to Claim 4, which has, as measured by X-ray powder diffraction with CuKα radiation (1.5418 Å), diffraction peaks at the following diffraction angles:

$2\theta = 4.86 \pm 0.20°$

$2\theta = 24.04 \pm 0.20°$

$2\theta = 26.25 \pm 0.20°$.

6. The oxide superconductor according to any one of Claims 2 to 5, which has a composition of the formula:

$Sr_\alpha Ca_\beta Bi_\gamma Cu_\delta O_x$

wherein, α, β, γ, δ and x are the numbers of moles of the respective elements, which satisfy:

$0.1 \leqq \alpha/\beta \leqq 1.5$

$0.8 \leqq \alpha/\gamma \leqq 2.0$

$0.25 \leqq \delta/(\alpha + \beta + \gamma + \delta) \leqq 0.65$.

7. The oxide superconductor according to any one of Claims 1 to 5, which has a composition of the formula:

$Sr_\alpha Ca_\beta Bi_\gamma Cu_\delta O_x$

wherein, α, β, γ, δ and x are the numbers of moles of the respective elements, which satisfy:

$0.1 \leqq \alpha/\beta \leqq 0.8$

$0.8 \leqq \alpha/\gamma \leqq 1.2$

$0.4 \leqq \delta/(\alpha + \beta + \gamma + \delta) \leqq 0.6.$

8. The oxide superconductor according to any one of Claims 1 to 7, wherein as measured by X-ray powder diffraction with CuKα radiation (1.5418 Å), the ratio of the intensity (H) of the diffraction peak at $2\theta = 24.04 \pm 0.20°$ to the intensity (L) of the diffraction peak at $2\theta = 23.29 \pm 0.20°$ specific to a substance having a structure analogous to an Auriillius phase comprising strontium, calcium, bismuth and copper, is:

$H/L \geqq 1.0.$

9. An oxide superconductor having a composition of the formula:

$Sr_{\alpha}Ca_{\beta}Bi_{\gamma}Cu_{\delta}O_{x}$

wherein, α, β, γ, δ and x are the numbers of moles of the respective elements, which satisfy:

$\alpha/\beta \leqq 1.0$

$0.8 \leqq \alpha/\gamma \leqq 1.2$

$0.45 \leqq \delta/(\alpha + \beta + \gamma + \delta) \leqq 0.8.$

10. An oxide superconductor having a composition of the formula:

$Sr_{\alpha}Ca_{\beta}Bi_{\gamma}Cu_{\delta}O_{x}$

wherein, α, β, γ, δ and x are the numbers of moles of the

respective elements, which satisfy:

$\alpha/\beta \leqq 0.8$

$0.8 \leqq \alpha/\gamma \leqq 1.2$

$0.35 \leqq \delta/(\alpha + \beta + \gamma + \delta) \leqq 0.65$

and having, as measured by X-ray powder diffraction with CuKα radiation (1.5418 Å), diffraction peaks at the following diffraction angles:

$2\theta = 4.9 \pm 0.2°$

$2\theta = 24.1 \pm 0.2°$

$2\theta = 26.3 \pm 0.2°$.

11. The oxide superconductor according to Claim 10, whereby the change rate (ΔX) in the magnetic susceptibility due to the temperature, as defined below, is at least 50%:

$\Delta X(\%) = X_1/(X_1 + X_2) \times 100$

where $X_1$: value of the change in the magnetic susceptibility showing diamagnetic susceptibility at a temperature of Tc to about 120 K, and

$X_2$: value of the change in magnetic susceptibility at the shoulder portion at a temperature of from 70 to 90 K.

12. A process for producing an oxide superconductor as defined in any one of Claims 1 to 11, which comprises subjecting a mixture of a strontium compound, a calcium compound, a bismuth compound and a copper compound to primary calcination in an oxygen-containing gas atmosphere at a temperature of at most 820°C until

bismuth oxide is no longer substantially observed, followed by second calcination at a temperature of from 865 to 880°C.

13. The process for producing an oxide superconductor according to Claim 12, wherein the bismuth compound is bismuth oxide.

14. The process for producing an oxide superconductor according to either Claim 12 or 13, wherein the second calcination is conducted for at least 24 hours.

15. The process for producing an oxide superconductor according to either Claim 12 or 13, wherein the second calcination is conducted for at least 120 hours.

16. An oxide superconductor having a composition of the formula:

$$Sr_{\alpha}Ca_{\beta}Bi_{\gamma}Cu_{\delta}X_{\varepsilon}O_{x}$$

wherein X is lead or chromium, and α, β, γ, δ, ε and x are the numbers of moles of the respective elements, which satisfy:

$\alpha/\beta \leqq 1.0$

$0 < \varepsilon/\beta \leqq 0.6$

$\gamma > 0$

$0.5 \leqq \alpha/(\gamma + \varepsilon) \leqq 1.2$

$0.25 \leqq \delta/(\alpha + \beta + \gamma + \delta + \varepsilon) \leqq 0.65.$

17. The oxide superconductor according to Claim 16, wherein $0.1 \leqq \varepsilon/\beta \leqq 0.3$.

18. An oxide superconductor having a composition of the formula:

$Sr_{\alpha}Ca_{\beta}Bi_{\gamma}Cu_{\delta}Pb_{\varepsilon}O_x$

wherein α, β, γ, δ, ε and x are the numbers of moles of the respective elements, which satisfy:

$\alpha = 2 \pm 0.1$

$\beta = \delta - 1$

$\gamma = 2 \pm 0.1$

$4.1 \leqq \delta \leqq 8$

$0.1 \leqq \varepsilon \leqq 0.6$

19. An oxide superconductor having a composition of the formula:

$Sr_{\alpha}Ca_{\beta}Bi_{\gamma}Cu_{\delta}Pb_{\varepsilon}O_x$

wherein α, β, γ, δ, ε and x are the numbers of moles of the respective elements, which satisfy:

$\alpha = 2 \pm 0.1$

$\beta = 3 \pm 0.1$

$\gamma = 2 \pm 0.1$

$\delta = 4 \pm 0.1$

$0.2 \leqq \varepsilon \leqq 1.0.$

20. An oxide superconductor having a composition of the formula:

$Sr_{\alpha}Ca_{\beta}Bi_{\gamma}Cu_{\delta}Cr_{\varepsilon}O_x$

wherein α, β, γ, δ, ε and x are the numbers of moles of the respective elements, which satisfy:

$1.8 \leqq \alpha \leqq 2.2$

$1.8 \leqq \beta \leqq 2.2$

$1.0 \leqq \gamma \leqq 2.2$

$2.7 \leqq \delta \leqq 3.3$

$0.1 \leqq \varepsilon \leqq 1.0$.

21. An oxide superconductor having a composition of the formula:

$Sr_\alpha Ca_\beta Bi_\gamma Cu_\delta V_\varepsilon O_x$

wherein α, β, γ, δ, ε and x are the numbers of moles of the respective elements, which satisfy:

$1.8 \leqq \alpha \leqq 2.2$

$1.8 \leqq \beta \leqq 2.2$

$\gamma = 2.0-\varepsilon$

$2.7 \leqq \delta \leqq 3.3$

$0.2 \leqq \varepsilon \leqq 0.8$.

22. A process for producing an oxide superconductor as defined in any one of Claims 16 to 20, which comprises subjecting a mixture of a strontium compound, a calcium compound, a bismuth compound, a copper compound and a lead compound or a chromium compound to primary calcination in an oxygen-containing gas atmosphere at a temperature of at most 820°C until bismuth oxide is no longer substantially observed, followed by second calcination at a temperature of from 840 to 855°C.

23. The process for producing an oxide superconductor according to Claim 21, wherein a mixture of a strontium compound, a calcium compound, a bismuth compound, a copper compound and a vanadium compound, is subjected to primary calcination in an oxygen-containing gas atmosphere at a temperature of at most 680°C until vanadium oxide is no longer substantially observed,

followed by second calcination at a temperature of 855 to 865°C.

FIGURE I

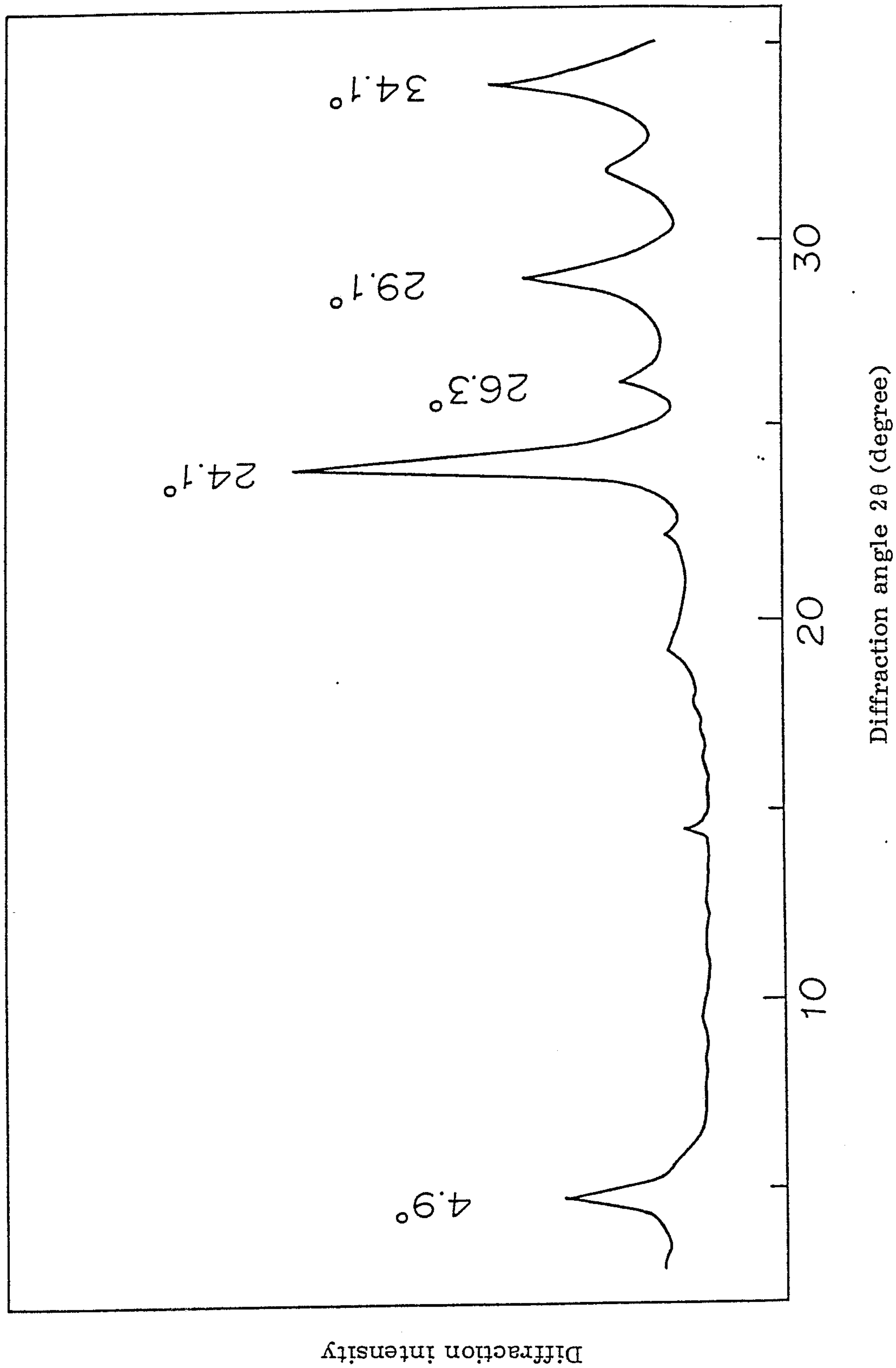
4.9°
24.1°
26.3°
29.1°
34.1°
10
20
30
Diffraction angle 2θ (degree)
Diffraction intensity

FIGURE 2

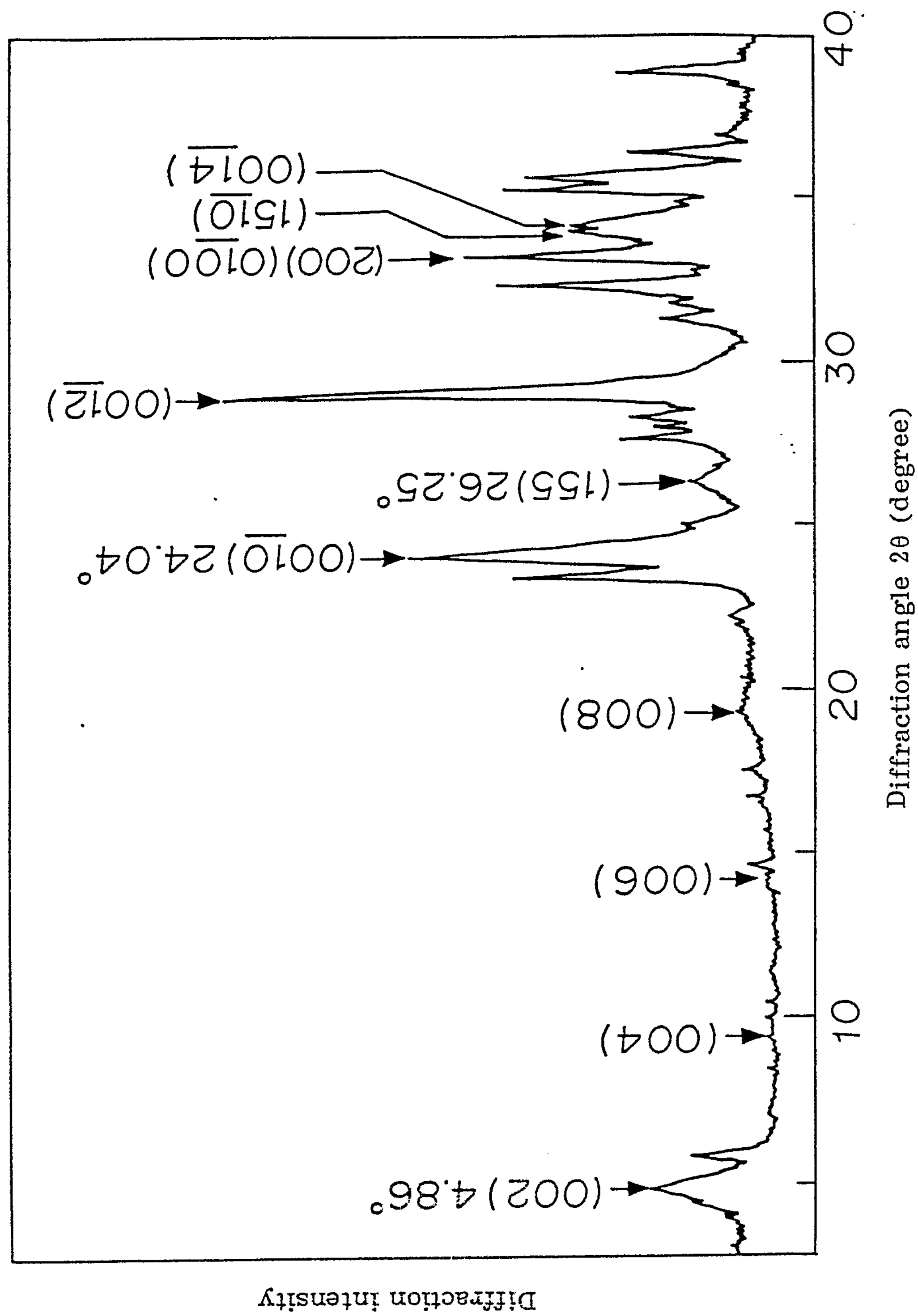
(002) 4.86°
(004)
(006)
(008)
(0010) 24.04°
(155) 26.25°
(0012)
(200)(0100)(0010)
(1510)
(0014)
10
20
30
40
Diffraction angle 2θ (degree)
Diffraction intensity

FIGURE 3

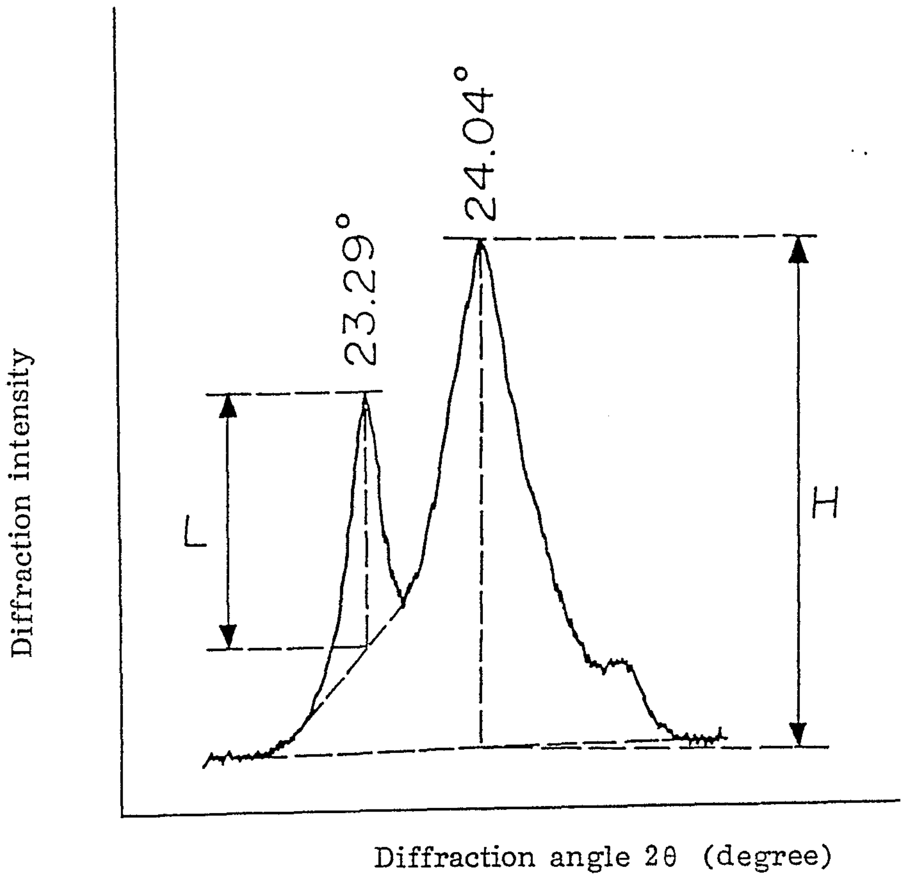
24.04°
23.29°
L
H
Diffraction intensity
Diffraction angle 2θ (degree)

FIGURE 4

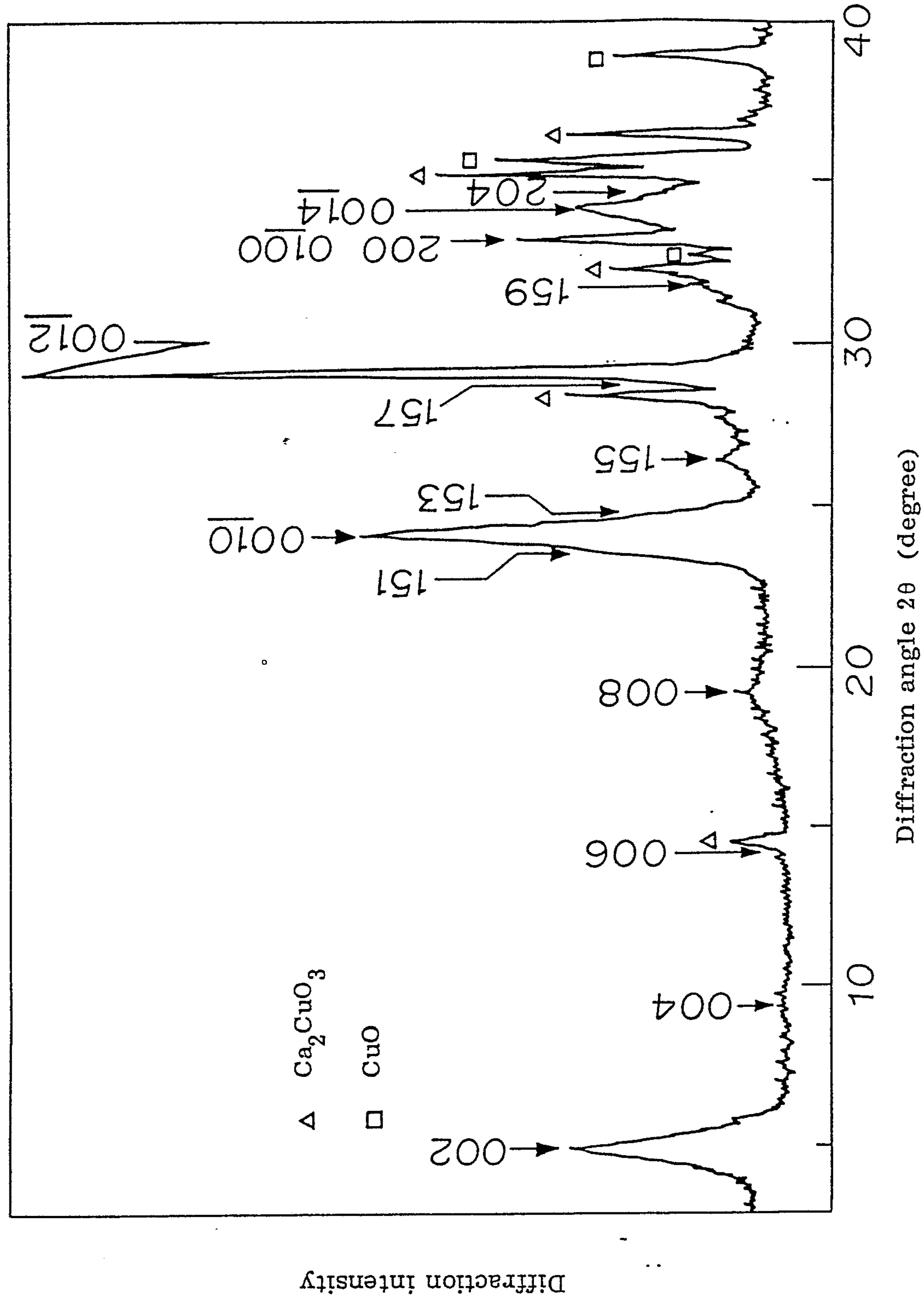
Diffraction intensity
Diffraction angle 2θ (degree)
10
20
30
40
△ $Ca_2CuO_3$
□ CuO
002
004
006
008
0010
151
153
155
157
0012
159
200
0010
0014
204

FIGURE 5

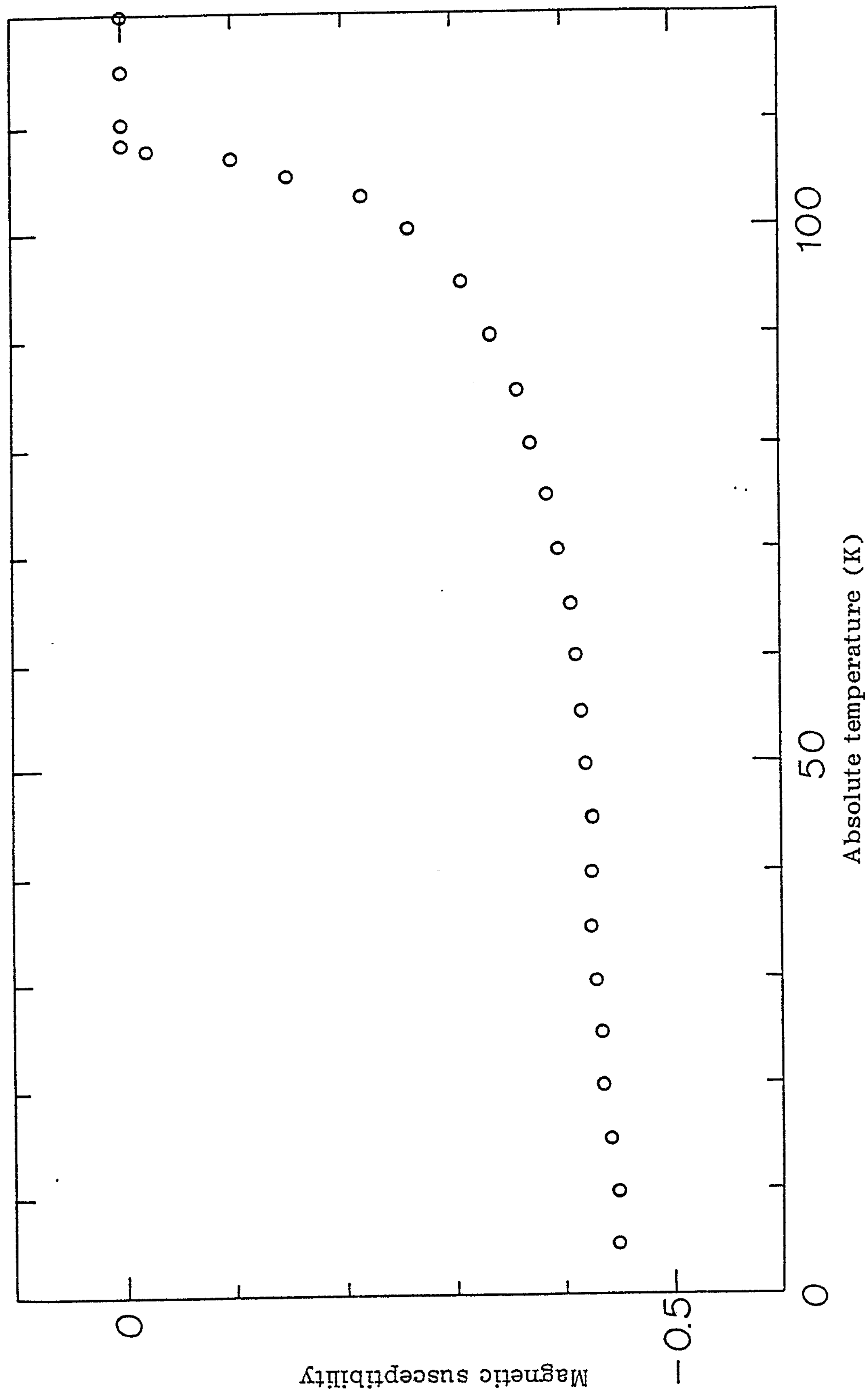
0
50
100
Absolute temperature (K)
0
-0.5
Magnetic susceptibility

FIGURE 6

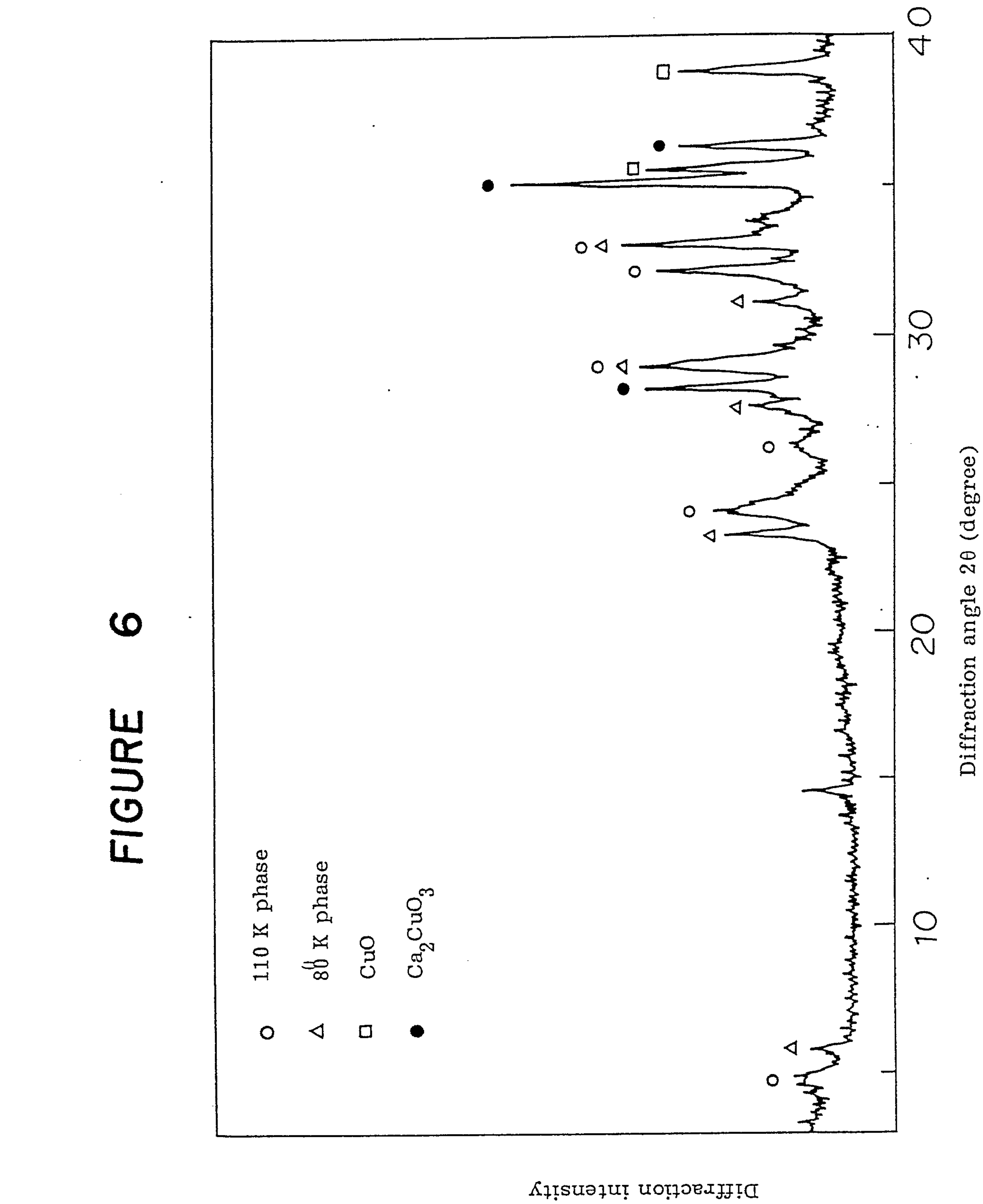

110 K phase
80 K phase
CuO
$Ca_2CuO_3$
10
20
30
40
Diffraction angle 2θ (degree)
Diffraction intensity

# FIGURE 7

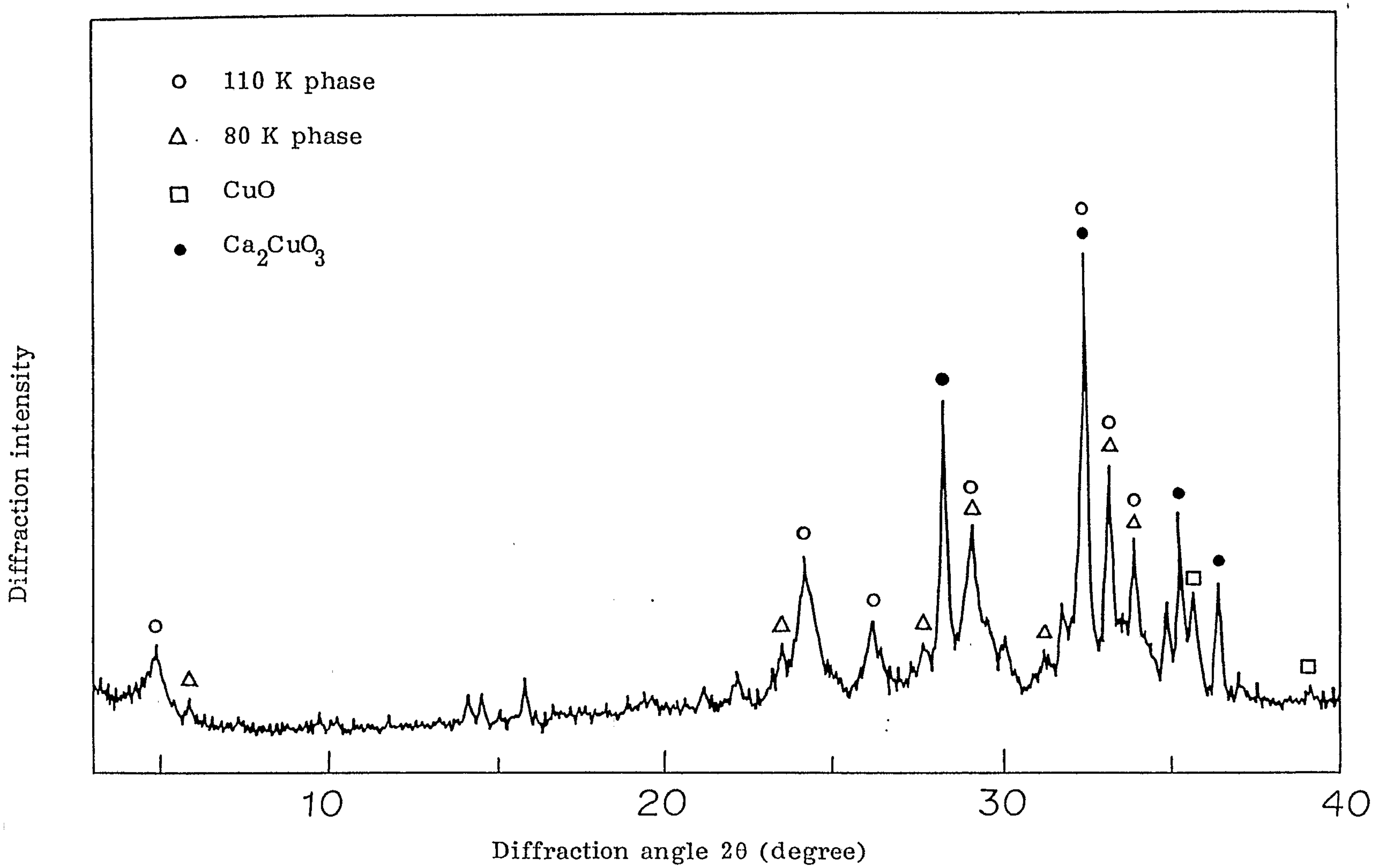

○ 110 K phase
△ 80 K phase
□ CuO
● $Ca_2CuO_3$
Diffraction intensity
10
20
30
40
Diffraction angle 2θ (degree)

FIGURE 8

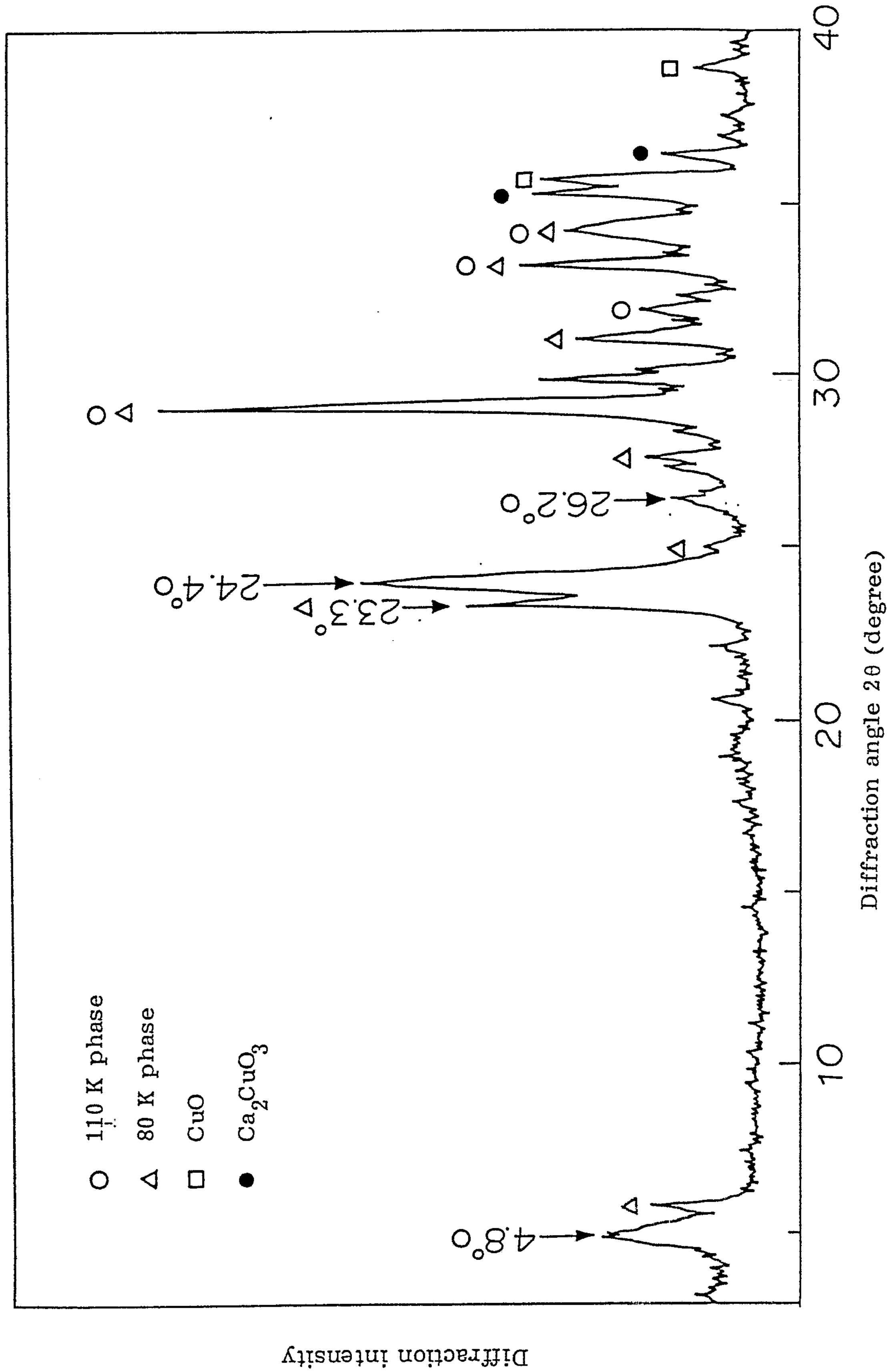

○ 110 K phase
△ 80 K phase
□ CuO
● $Ca_2CuO_3$
4.8°
23.3°
24.4°
26.2°
10
20
30
40
Diffraction angle 2θ (degree)
Diffraction intensity

FIGURE 9

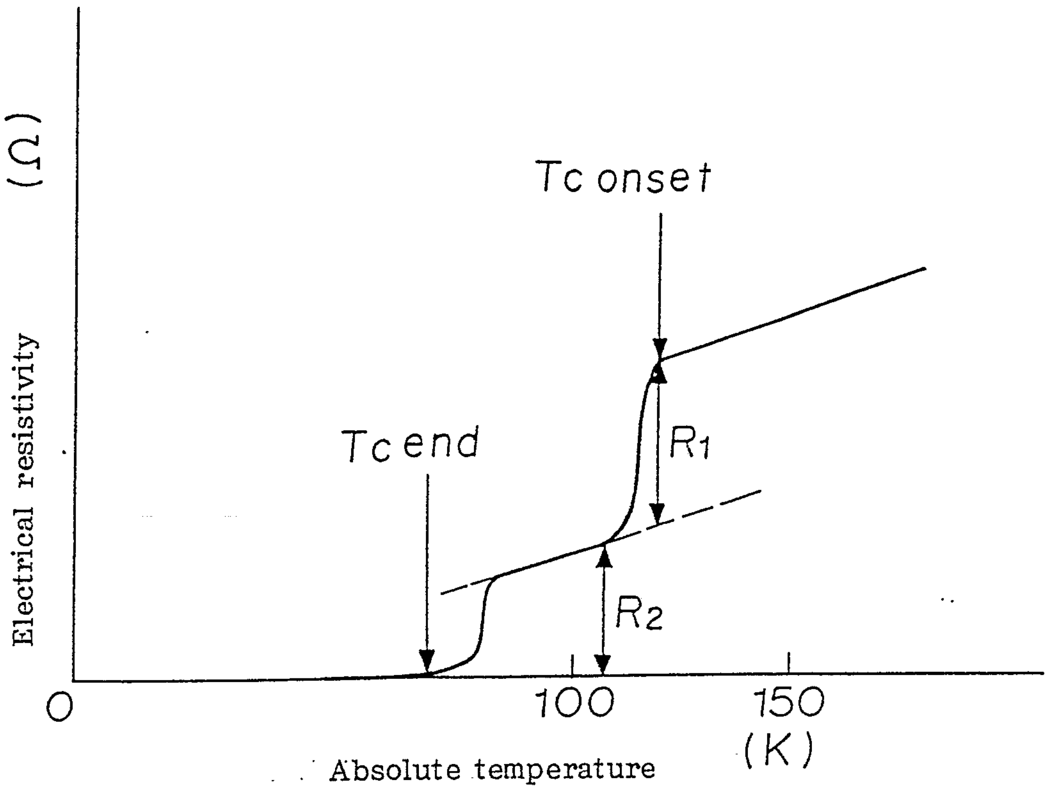


FIGURE 10

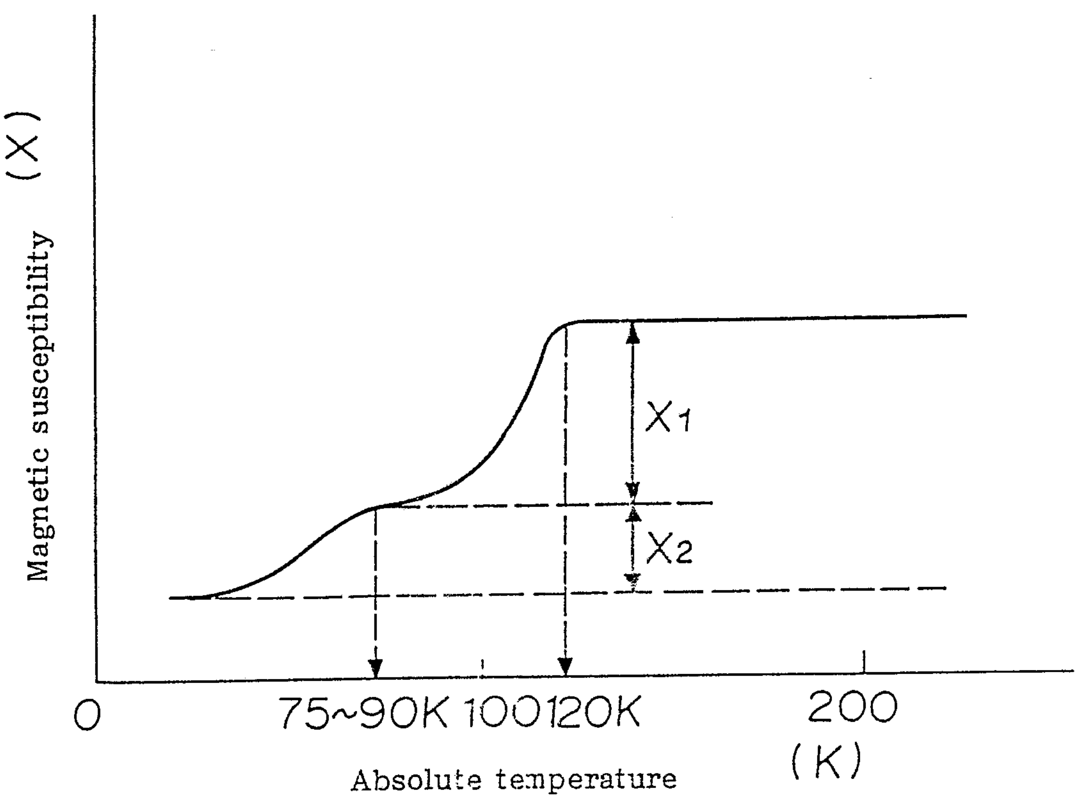

# INTERNATIONAL SEARCH REPORT

International Application No PCT/JP89/00133

**I. CLASSIFICATION OF SUBJECT MATTER** (if several classification symbols apply, indicate all) [8]

According to International Patent Classification (IPC) or to both National Classification and IPC

Int. $Cl^4$ C01G29/00, C04B35/00, H01B12/00, H01B13/00

**II. FIELDS SEARCHED**

Minimum Documentation Searched [7]

| Classification System | Classification Symbols |
|---|---|
| IPC | C01G29/00, C04B35/00, H01B12/00, H01B13/00 |

Documentation Searched other than Minimum Documentation to the Extent that such Documents are Included in the Fields Searched [8]

**III. DOCUMENTS CONSIDERED TO BE RELEVANT** [9]

| Category * | Citation of Document, [11] with indication, where appropriate, of the relevant passages [12] | Relevant to Claim No. [13] |
|---|---|---|
| A | Nikkan Kogyo Shimbun Chokan, 22 January 1988 (22. 01. 88) [Chodendo Kidorui fukumanai Busshitsu Kaihatsu Kinzaiken ga 5 Gensokei] (Family: none) | 1-10<br>12-15 |
| P | JAPANESE JOURNAL of APPLIED PHYSICS Vol. 27, No.2, (February 1988) (Tokyo) Hiroshi Maeda, et al [A New High-Tc Oxide Superconductor without a Rare Earth Element] P.L209-L210 | 1-10 |
| P | JAPANESE JOURNAL of APPLIED PHYSICS Vol. 27, No.4 (April 1988) (Tokyo) Hiroyuki Nasu, et al [Formation of High-Tc Superconducting $BiSrCaCu_2Ox$ Films on $ZrO_2$/Si(100)] P.L634-L635 | 1-10 |

* Special categories of cited documents: [10]
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step
"Y" document of particular relevance; the claimed invention cannot be considered to involve an inventive step when the document is combined with one or more other such documents, such combination being obvious to a person skilled in the art
"&" document member of the same patent family

**IV. CERTIFICATION**

| Date of the Actual Completion of the International Search | Date of Mailing of this International Search Report |
|---|---|
| May 1, 1989 (01. 05. 89) | May 15, 1989 (15. 05. 89) |
| **International Searching Authority** | **Signature of Authorized Officer** |
| Japanese Patent Office | |

FURTHER INFORMATION CONTINUED FROM THE SECOND SHEET

| | | |
|---|---|---|
| P | JAPANESE JOURNAL of APPLIED PHYSICS Vol. 27, No. 9 (September 1988) (Tokyo) Hiromasa Mazaki, et al [Complex Susceptibility of Bi, Pb-Sr-Ca-Cu-O Superconductors] P.L1639-L1641 | 16-19 |

V.☐ OBSERVATIONS WHERE CERTAIN CLAIMS WERE FOUND UNSEARCHABLE [1]

This international search report has not been established in respect of certain claims under Article 17(2) (a) for the following reasons:

1.☐ Claim numbers , because they relate to subject matter not required to be searched by this Authority, namely:

2.☐ Claim numbers . ... . , because they relate to parts of the international application that do not comply with the prescribed requirements to such an extent that no meaningful international search can be carried out, specifically:

3.☐ Claim numbers ........., because they are dependent claims and are not drafted in accordance with the second and third sentences of PCT Rule 6.4(a).

VI.☐ OBSERVATIONS WHERE UNITY OF INVENTION IS LACKING [2]

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest

☐ No protest accompanied the payment of additional search fees.